# EUROPÄISCHE PATENTANMELDUNG

(11) **EP 1 354 640 A1**
(43) Veröffentlichungstag der Anmeldung: **22.10.2003**
(21) Anmeldenummer: 02008255.8
(22) Anmeldetag: 19.04.2002
(51) Int. Cl.: B05D 3/14

(54) **Verfahren und Vorrichtung zum Härten einer Beschichtung**

(71) Anmelder: Dürr Systems GmbH, 70435 Stuttgart (DE)
(72) Erfinder: Ortlieb Konrad Dr., 70186 Stuttgart (DE); Wieland Dietmar, 70180 Stuttgart (DE); Tobisch Wolfgang, 70193 Stuttgart (DE); Roth Dietmar, Dr., 09353 Oberlungwitz (DE); Dittrich Karl-Heinz Dr., 09125 Chemnitz, (DE)
(74) Vertreter: Hoeger, Stellrecht & Partner

(57) **Zusammenfassung**

Um ein Verfahren zum Härten einer, insbesondere strahlungshärtbaren, Beschichtung an einem Werkstück zu schaffen, welches es ermöglicht, Beschichtungen auch an schwer zugänglichen Bereichen eines dreidimensionalen Werkstücks in einfacher Weise auszuhärten, wird vorgeschlagen, daß das Werkstück in einem Plasmaerzeugungsraum angeordnet wird und daß in dem Plasmaerzeugungsraum ein Plasma erzeugt wird, mittels dessen die Beschichtung zumindest teilweise gehärtet wird.

## Beschreibung

Die vorliegende Erfindung betrifft ein Verfahren und eine Vorrichtung zum Härten einer, insbesondere strahlungshärtbaren, Beschichtung an einem Werkstück.

Es ist aus dem Stand der Technik bekannt, Werkstücke mit einer Beschichtung aus einem Material zu versehen, welches unter Bestrahlung mit UV-Licht aushärtet, und das so beschichtete Werkstück anschließend mit UV-Strahlung zu beaufschlagen.

Insbesondere ist es bekannt, Werkstücke, beispielsweise Fahrzeugkarosserien, mit einem UV-härtbaren Klarlack zu beschichten und diese Beschichtung durch Bestrahlung des Werkstücks mit UV-Licht auszuhärten.

Solche UV-härtbaren Klarlacke zeichnen sich durch eine besonders hohe Kratzbeständigkeit aus.

Bei den bekannten Verfahren und Vorrichtungen zum Härten von UV-härtbaren Beschichtungen werden die beschichteten Werkstücke mittels aus UV-Lampen stammendem UV-Licht bestrahlt.

Weisen die beschichteten Werkstücke eine komplexe, dreidimensionale Geometrie mit Hinterschneidungen und abgeschatteten Bereichen auf, so ist es erforderlich, die UV-Lampen an Handhabungseinrichtungen einzuordnen, die relativ zu dem Werkstück beweglich sind, damit sämtliche beschichteten Oberflächen des Werkstücks von den UV-Lampen überstrichen werden können. Da die UV-Lampen sperrig sind, kann selbst bei Verwendung solcher Handhabungseinrichtungen nicht jeder Hinterschneidungsbereich oder in sonstiger Weise abgeschatteter Bereich durch das UV-Licht erreicht werden. Die nicht von dem UV-Licht erreichten Bereiche der Beschichtung können nicht aushärten, was dazu führt, daß Bestandteile der nicht ausgehärteten Beschichtung während der Betriebsdauer des Werkstückes ausdünsten und so eine lang andauernde, gesundheitsschädliche Geruchsbelastung entsteht.

Um dieses Problem zu umgehen, ist es bereits bekannt, hybride Lacksysteme zu verwenden, die sowohl durch UV-Strahlung als auch durch Wärmezufuhr ausgehärtet werden können. Ein solches hybrides Lacksystem erlaubt es, die für UV-Lampen gut zugänglichen Bereiche des Werkstücks mittels UV-Strahlung und die schlecht zugänglichen Bereiche des Werkstücks durch Wärmekonvektion auszuhärten. Nachteilig ist, daß zum vollständigen Aushärten eines solchen hybriden Lacksystems zwei völlig verschiedene Verfahrensschritte, nämlich die UV-Bestrahlung und die Härtung durch Wärmekonvektion, nacheinander durchgeführt werden müssen, was einen hohen zeitlichen und einen hohen apparativen Aufwand zur Folge hat, da sowohl die UV-Lampen als auch geeignete Heizeinrichtungen in der Härtungsvorrichtung vorhanden sein müssen.

Der vorliegenden Erfindung liegt daher die Aufgabe zugrunde, ein Verfahren zum Härten von, insbesondere strahlungshärtbaren, Beschichtungen zu schaffen, welches es ermöglicht, Beschichtungen auch an schwer zugänglichen Bereichen eines dreidimensionalen Werkstücks in einfacher Weise auszuhärten.

Diese Aufgabe wird bei einem Verfahren mit den Merkmalen des Oberbegriffs von Anspruch 1 erfindungsgemäß dadurch gelöst, daß das Werkstück in einem Plasmaerzeugungsraum angeordnet wird und daß in dem Plasmaerzeugungsraum ein Plasma erzeugt wird, mittels dessen die Beschichtung zumindest teilweise gehärtet wird.

Der erfindungsgemäßen Lösung liegt die Erkenntnis zugrunde, daß ein Plasma zum Härten der Beschichtung verwendet werden kann. Dadurch, daß das Werkstück selbst innerhalb des Plasmaerzeugungsraums angeordnet ist und sich das Werkstück innerhalb des erzeugten Plasmas befindet, kann die Beschichtung an allen Oberflächen des Werkstücks, auch an schwer zugänglichen inneren Oberflächen, gehärtet werden.

Das Plasma kann die Härtung der Beschichtung insbesondere dadurch bewirken, daß die Beschichtung strahlungshärtbar ist und in dem Plasma eine zum Härten der Beschichtung geeignete Strahlung erzeugt wird.

Dadurch, daß das Werkstück selbst innerhalb des Plasmaerzeugungsraums angeordnet ist und sich das Werkstück Innerhalb des erzeugten Plasmas befindet, kann die von dem Plasma emittierte Strahlung von verschiedenen Seiten her zu dem Werkstück gelangen. Insbesondere kann das Plasma auch innerhalb von Hohlräumen des Werkstücks erzeugt werden, so daß die Begrenzungsflächen dieser Hohlräume aus dem Hohlraum selbst mit zum Härten der Beschichtung geeigneter Strahlung beaufschlagt werden. Auf diese Weise kann die zum Härten der Beschichtung geeignete Strahlung an jede beliebige beschichtete Oberfläche des Werkstücks gelangen, insbesondere auch an Hinterschneidungsbereiche oder abgeschattete Bereiche des Werkstücks, so daß die an dem Werkstück vorhandene strahlungshärtbare Beschichtung vollständig ausgehärtet werden kann, ohne daß hierfür komplizierte und aufwendige Handhabungseinrichtungen erforderlich wären.

Vorzugsweise wird die Beschichtung mittels des Plasmas im wesentlichen vollständig gehärtet. In diesem Fall erfordert das erfindungsgemäße Verfahren nur einen einzigen Prozeßschritt, nämlich die Plasmahärtung, so daß das erfindungsgemäße Härtungsverfahren zeitsparend und mit geringem apparativem Aufwand durchgeführt werden kann.

Außerdem reicht es aus, wenn die Beschichtung strahlungshärtbar ist; die Beschichtung muß insbesondere nicht zugleich wärmehärtbar sein, so daß auf komplexe hybride Lacksysteme verzichtet werden kann.

Durch den Verzicht auf die Wärmehärtbarkeit kann für die Beschichtung ein strahlungshärtbares Material verwendet werden, welches eine höhere Qualität, insbesondere eine höhere Kratzbeständigkeit, aufweist.

Da das Plasma bei dem erfindungsgemäßen Verfahren in dem Plasmaerzeugungsraum stets den nicht vom Werkstück eingenommenen Raum einnimmt, hat eine Änderung der Werkstückgeometrie nur geringe oder gar keine Auswirkungen auf den Prozeßverlauf.

Da die Aushärtung der Beschichtung durch Bestrahlung erfolgt und nicht, zumindest nicht ausschließlich, durch Wärmekonvektion, ist es nicht erforderlich, das gesamte Werkstück zum Aushärten der Beschichtung aufzuheizen.

Dadurch wird der für die Aushärtung erforderliche Energieaufwand deutlich reduziert.

Vor, während oder nach dem Plasmahärtungsvorgang kann ein separater Wärmehärtungsvorgang, beispielsweise durch Wärmekonvektion und/oder durch Bestrahlung mit infrarotem Licht, vorgesehen sein.

Bei einer bevorzugten Ausgestaltung der Erfindung ist vorgesehen, daß In dem Plasma eine elektromagnetische Strahlung erzeugt wird, die zumindest einen Anteil von UV-Strahlung enthält.

Unter "UV-Strahlung" wird in dieser Beschreibung und den beigefügten Ansprüchen elektromagnetische Strahlung mit einer Wellenlänge im Bereich von 1 nm bis 400 nm verstanden.

Durch geeignete Wahl der Zusammensetzung des Prozeßgases, aus dem das Plasma erzeugt wird, und der Art der Energieeinkopplung in das Plasma sowie des Arbeitsdrucks des Plasmas können der Wellenlängenbereich und die Dosis der im Plasma erzeugten elektromagnetischen Strahlung beeinflußt werden.

Der Anteil extrem kurzwelliger Strahlung mit einer Wellenlänge unterhalb von 100 nm sollte möglichst klein gehalten werden, um eine Schädigung der auszuhärtenden Beschichtung zu vermeiden.

Ferner hat es sich für die Qualität der ausgehärteten Beschichtung als vorteilhaft erwiesen, die Zeitdauer, während derer die Beschichtung der Bestrahlung aus dem Plasma ausgesetzt ist, auf höchstens ungefähr 120 Sekunden, vorzugsweise höchstens ungefähr 90 Sekunden, zu begrenzen.

Vorzugsweise wird das Plasma in der Weise erzeugt, daß das Plasma eine elektromagnetische Strahlung mit einer Wellenlänge im Bereich von ungefähr 50 nm bis ungefähr 850 nm, insbesondere im Bereich von ungefähr 50 nm bis ungefähr 700 nm, vorzugsweise im Bereich von ungefähr 150 nm bis ungefähr 700 nm, besonders bevorzugt im Bereich von ungefähr 200 nm bis ungefähr 600 nm, emittiert.

Besonders günstig ist es, wenn die vom Plasma emittierte Strahlung zumindest einen Anteil von UV-Strahlung, vorzugsweise im Bereich von ungefähr 200 nm bis ungefähr 400 nm, emittiert.

Das Werkstück ist vorteilhafterweise mit einer strahlungshärtbaren Beschichtung versehen, die mit der von dem Plasma emittierten Strahlung ausgehärtet werden kann.

Besonders günstig ist es, wenn das Werkstück mit einer Beschichtung versehen ist, die durch eine elektromagnetische Strahlung, welche zumindest einen Anteil im UV-Bereich umfaßt, vorzugsweise im Bereich von ungefähr 200 nm bis ungefähr 400 nm, härtbar ist.

Als besonders günstig für die Erzeugung eines hohe Dosen von zum Härten der Beschichtung geeigneter Strahlung emittierenden Plasmas hat es sich erwiesen, wenn der Druck in dem Plasmaerzeugungsraum auf einen Wert von höchstens ungefähr 100 Pa, vorzugsweise von höchstens ungefähr 1 Pa, insbesondere von höchstens ungefähr 0,1 Pa, eingestellt wird.

Ferner bietet das Arbeiten bei solch niedrigen Drücken den Vorteil, daß die Aushärtung der Beschichtung im wesentlichen unter Sauerstoffausschluß erfolgt. Da Sauerstoff als Inhibitor für die Vernetzungsreaktion der Beschichtung fungiert, kann die Aushärtung der Beschichtung unter Vakuum schneller ablaufen, und/oder die in das Plasma einzuspeisende Leistung kann im Vergleich zu einer in einer Sauerstoffatmosphäre ablaufenden Vernetzungsreaktion reduziert werden.

Als Prozeßgas, aus dem das Plasma erzeugt wird, sollte ein Gas verwendet werden, das chemisch inert und leicht zu ionisieren ist.

Als besonders günstig hat es sich erwiesen, wenn der Plasmaerzeugungsraum als Prozeßgas Stickstoff und/oder ein Edelgas, vorzugsweise Argon, enthält.

Ferner kann es zur Erhöhung der Ausbeute an nutzbarer Strahlung von Vorteil sein, wenn dem Prozeßgas ein Metall, beispielsweise Quecksilber, oder ein Metallhalogenid, beispielsweise OsF₇ oder IrF₆, zugemischt ist.

Das Plasma kann grundsätzlich dadurch erzeugt werden, daß entweder ein statisches elektrisches Feld an den Plasmaerzeugungsraum angelegt wird, und/oder daß ein elektromagnetisches Wechselfeld in den Plasmaerzeugungsraum eingekoppelt wird.

Vorzugsweise ist vorgesehen, daß das Plasma durch Einkopplung von elektromagnetischer Strahlung in den Plasmaerzeugungsraum mittels mindestens einer Einkopplungseinrichtung erzeugt wird.

Die Frequenz dieser in den Plasmaerzeugungsraum eingekoppelten elektromagnetischen Strahlung kann im Mikrowellenbereich oder im Hochfrequenzbereich liegen.

Dabei wird in dieser Beschreibung und den beigefügten Ansprüchen unter Mikrowellenstrahlung eine elektromagnetische Strahlung mit einer Frequenz im Bereich von 300 MHz bis 300 GHz und unter Hochfrequenzstrahlung eine elektromagnetische Strahlung mit einer Frequenz von 3 kHz bis 300 MHz verstanden.

Als zur Erzeugung hoher Dosen von UV-Strahlung besonders geeignet hat sich die Verwendung von Mikrowellenstrahlung erwiesen.

Bei einer bevorzugten Ausgestaltung der Erfindung ist daher vorgesehen, daß das Plasma durch Einkopplung von Mikrowellenstrahlung, vorzugsweise mit einer Frequenz im Bereich von ungefähr 1 GHz bis ungefähr 10 GHz, insbesondere im Bereich von ungefähr 2 GHz bis ungefähr 3 GHz, erzeugt wird.

Die einzukoppelnde elektromagnetische Strahlung kann insbesondere mittels eines Magnetrons erzeugt werden.

Um die ionisierende Wirkung der eingekoppelten elektromagnetischen Strahlung zu erhöhen, kann vorgesehen sein, daß ein Magnetfeld zur Erzeugung eines ECR ("Electron Cyclotron Resonance")-Effektes erzeugt wird. Hierbei wird, beispielsweise mittels einer Magnetspulenanordnung, ein statisches Magnetfeld erzeugt, welches innerhalb des Plasmaerzeugungsraums im wesentlichen parallel zur Achse des in den Plasmaerzeugungsraums eingekoppelten elektromagnetischen Wechselfeldes ausgerichtet ist. Die Stärke des Magnetfelds wird so eingestellt, daß die Zyklotronfrequenz der Elektronen in dem Magnetfeld der Frequenz der eingekoppelten elektromagnetischen Strahlung entspricht. In diesem Resonanzfall nehmen die freien Elektronen im Plasmaerzeugungsraum besonders viel Energie aus dem elektromagnetischen Wechselfeld auf, was zu einer besonders effizienten Ionisierung des Prozeßgases führt.

Um an verschiedenen Stellen des Plasmas jeweils möglichst hohe Ionendichten erzeugen zu können, kann vorgesehen sein, daß die elektromagnetische Strahlung mittels mehrerer Einkopplungseinrichtungen in den Plasmaerzeugungsraum eingekoppelt wird, wobei die Einkopplungseinrichtungen vorzugsweise auf verschiedenen Seiten relativ zum Werkstück angeordnet sind.

Wenn das zu behandelnde Werkstück einen Hohlraum mit einer Zugangsöffnung aufweist, so wird die elektromagnetische Strahlung vorteilhafterweise mittels mindestens einer Einkopplungseinrichtung so in den Plasmaerzeugungsraum eingekoppelt, daß die elektromagnetische Strahlung durch die Zugangsöffnung in den Hohlraum des Werkstücks gelangt. Dadurch ist gewährleistet, daß auch in dem Hohlraum des Werkstücks ein Plasma mit einer hohen Ionendichte und einer entsprechend hohen UV-Emission erzeugt wird, so daß die Beschichtung an den Begrenzungsflächen des Hohlraums rasch ausgehärtet werden kann.

Wenn es sich bei dem Werkstück um eine Fahrzeugkarosserie handelt, so ist es besonders wichtig, den beim Lackieren der Fahrzeugkarosserle in deren Innenraum hinein gelangenden Lack-Overspray auszuhärten. Dies wird bei dem erfindungsgemäßen Verfahren insbesondere dadurch erleichtert, daß Einkopplungseinrichtungen für elektromagnetische Strahlung den Fensteröffnungen der Fahrzeugkarosserie gegenüberliegend angeordnet sind, und zwar derart, daß die Achse des von der Einkopplungseinrichtung erzeugten Strahlungsfeldes durch die betreffende Fensteröffnung in den Innenraum der Fahrzeugkarosserie hinein weist.

Bei einer bevorzugten Ausgestaltung der Erfindung ist vorgesehen, daß dem Plasmaerzeugungsraum während des Härtungsvorganges ein zu ionisierendes Gas zugeführt wird.

Das zu ionisierende Gas kann insbesondere Stickstoff oder ein Edelgas, beispielsweise Argon, sein.

Durch die kontinuierliche Zufuhr von zu ionisierendem Gas zu dem Plasmaerzeugungsraum während des Härtungsvorganges kann in dem Plasmaerzeugungsraum eine Strömung erzeugt werden, durch welche ionisierte Gasteilchen und/oder durch Stöße mit ionisierten Teilchen angeregte Gasteilchen auch in abgeschattete Bereiche des Werkstücks gelangen können, in welche die eingekoppelte elektromagnetische Strahlung nicht hineingelangt und wo daher kein Plasma gezündet werden kann.

Außerdem wird durch die Erzeugung einer Gasströmung in dem Plasmaerzeugungsraum ein möglichst homogener und isotroper Zustand des Plasmas und somit eine möglichst orts- und richtungsunabhängige Dosis der zur Härtung der Beschichtung geeigneten Strahlung erreicht.

Besonders günstig ist es, wenn das zu ionisierende Gas dem Plasmaerzeugungsraum mittels einer Einspeiseinrichtung zugeführt wird, die einer Einkopplungseinrichtung benachbart ist, mittels welcher eine elektromagnetische Strahlung in den Plasmaerzeugungsraum eingekoppelt wird. Wenn das Gas vor der Verteilung im Plasmaerzeugungsraum möglichst nahe an der Einspeisstelle der elektromagnetischen Strahlung vorbeigeleitet wird, wird in dem eingeleiteten Gas eine besonders hohe Ionendichte erzeugt, die durch die Gasströmung anschließend im gesamten Plasmaerzeugungsraum verteilt wird.

Um das erfindungsgemäße Verfahren besonders zeitsparend durchführen zu können, kann vorgesehen sein, daß das Werkstück vor dem Härtungsvorgang in eine Vorkammer eingebracht, dort einer Vorbehandlung unterzogen wird und für den Härtungsvorgang aus der Vorkammer in den Plasmaerzeugungsraum überführt wird.

Insbesondere kann vorgesehen sein, daß die Vorkammer nach dem Einbringen des Werkstücks evakuiert wird, so daß die Vorkammer in diesem Fall als Einschleuskammer dient, in welcher der Umgebungsdruck des Werkstücks vom Atmosphärendruck auf den Arbeitsdruck des Plasmaerzeugungsraums abgesenkt wird.

Durch die Evakuierung der Vorkammer kommt es zu einem Vorabdampfen von in der Beschichtung enthaltenen Lösemitteln, so daß in der Vorkammer bereits eine Vortrocknung der auszuhärtenden Beschichtung erfolgt.

Alternativ oder ergänzend hierzu kann vorgesehen sein, daß das Werkstück in der Vorkammer mit elektromagnetischer Strahlung, insbesondere mit Mikrowellenstrahlung, beaufschlagt wird. Hierbei kann die auszuhärtende Beschichtung insbesondere durch direkte Absorption der Energie aus der elektromagnetischen Strahlung vorgetrocknet werden. Alternativ oder ergänzend hierzu ist es auch möglich, bereits in der Vorkammer ein Plasma zu zünden, welches zur Härtung der Beschichtung geeignete Strahlung emittiert, um somit bereits einen ersten Härtungsvorgang der Beschichtung zu bewirken.

Ferner kann vorgesehen sein, daß das Werkstück nach dem Härtungsvorgang aus dem Plasmaerzeugungsraum in eine Ausschleuskammer überführt wird.

Insbesondere kann vorgesehen sein, daß die Ausschleuskammer vor dem Überführen des Werkstücks in die Ausschleuskammer auf den Arbeitsdruck des Plasmaerzeugungsraums evakuiert wird.

Nach dem Überführen des Werkstücks in die Ausschleuskammer kann die Ausschleuskammer belüftet, d.h. der Druck in der Ausschleuskammer auf Atmosphärendruck erhöht, werden und anschließend das Werkstück aus der Ausschleuskammer entnommen werden.

Anspruch 21 ist auf ein Werkstück mit einer Beschichtung gerichtet, die nach dem erfindungsgemäßen Verfahren gehärtet worden ist.

Das Werkstück kann jeden beliebigen, insbesondere metallischen und/oder nicht metallischen, Werkstoff umfassen.

Insbesondere kann das Werkstück beispielsweise aus Stahl, Kunststoff oder aus Holz gefertigt sein.

Der vorliegenden Erfindung liegt die weitere Aufgabe zugrunde, eine Vorrichtung zum Härten einer, Insbesondere strahlungshärtbaren, Beschichtung an einem Werkstück zu schaffen, welche es ermöglicht, Beschichtungen auch an schwer zugänglichen Stellen des Werkstücks in einfacher Weise auszuhärten.

Diese Aufgabe wird bei einer Vorrichtung mit den Merkmalen des Oberbegriffs von Anspruch 22 erfindungsgemäß dadurch gelöst, daß die Vorrichtung einen Plasmaerzeugungsraum, eine Einrichtung zum Einbringen des Werkstücks in den Plasmaerzeugungsraum und eine Einrichtung zum Erzeugen eines Plasmas in dem Plasmaerzeugungsraum umfaßt.

Das in dem Plasmaerzeugungsraum erzeugte Plasma kann insbesondere die zum Härten einer strahlungshärtbaren Beschichtung erforderliche Strahlung emittieren.

Besondere Ausgestaltungen der erfindungsgemäßen Vorrichtung sind Gegenstand der abhängigen Ansprüche 23 bis 40, deren Vorteile bereits vorstehend im Zusammenhang mit den besonderen Ausgestaltungen des erfindungsgemäßen Verfahrens erläutert worden sind.

Weitere Merkmale und Vorteile der Erfindung sind Gegenstand der nachfolgenden Beschreibung und der zeichnerischen Darstellung von Ausführungsbeispielen.

In den Zeichnungen zeigen:
- Fig. 1: eine schematische Prinzipdarstellung der Härtung einer strahlungshärtbaren Beschichtung an einem Werkstück in einem Plasma;
- Fig. 2: eine schematische Schnittdarstellung einer ersten Ausführungsform einer Vorrichtung zum Härten einer strahlungshärtbaren Beschichtung an einem Werkstück;
- Fig. 3: eine schematische Schnittdarstellung einer zweiten Ausführungsform einer Vorrichtung zum Härten einer strahlungshärtbaren Beschichtung an einem Werkstück;
- Fig. 4: einen schematischen Längsschnitt durch eine Vorrichtung zum Härten einer strahlungshärtbaren Beschichtung an Fahrzeugkarosserien, welche eine Einschleuskammer, eine Plasmakammer und eine Ausschleuskammer umfaßt;
- Fig. 5: einen schematischen Querschnitt durch die Vorrichtung aus Fig. 4 längs der Linie 5-5 In Fig. 4; und
- Fig. 6 bis 10: schematische Seitenansichten der Vorrichtung aus den Fig. 4 und 5 in aufeinanderfolgenden Phasen eines Arbeitszyklus der Vorrichtung.

Gleiche oder funktional äquivalente Elemente sind in allen Figuren mit denselben Bezugszeichen bezeichnet.

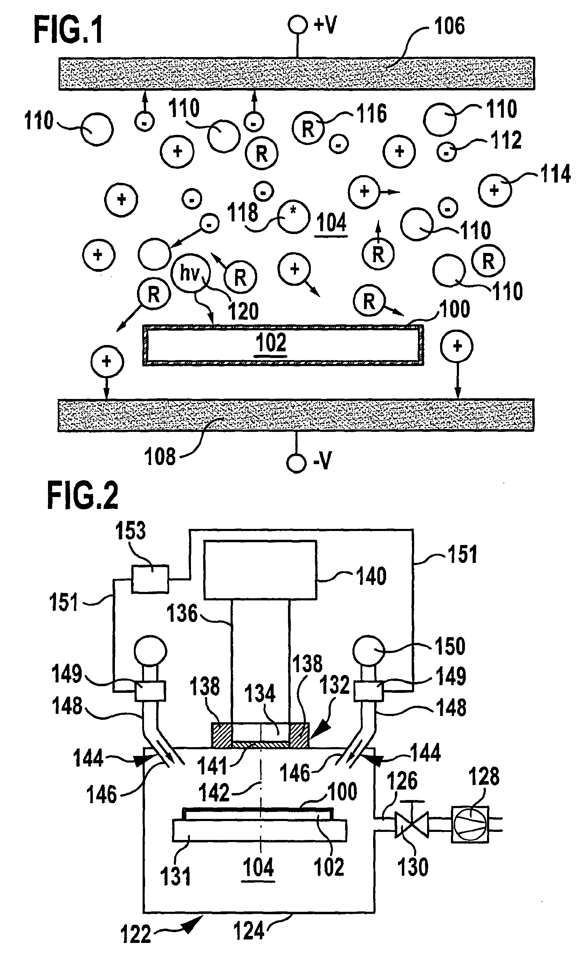

In Fig. 1 ist das Funktionsprinzip eines Verfahrens zur Härtung einer strahlungshärtbaren Beschichtung 100 an einem Werkstück 102, das in einem Plasmaerzeugungsraum 104 angeordnet ist, dargestellt.

Die Beschichtung 100 ist aus einem Material gebildet, welches durch Bestrahlung mit ultravioletter Strahlung aushärtbar ist.

Formulierungen für solche strahlungshärtbaren Materialien sind in der Technik bekannt und vielfach publiziert. So enthalten diese Formulierungen beispielsweise zu polymerisierende Anteile, wie die Monomere, Oligomere und/oder Polymere, gegebenenfalls Bindemittel, einen oder mehrere Photoinitiatoren, und gegebenenfalls weitere übliche Lackzusätze, wie beispielsweise Lösungsmittel, Verlaufshilfsmittel, Adhäsionsverbesserer, Stabilisatoren, z.B. Lichtschutzmittel, UV-Absorber.

Beispiele für geeignete Monomere sind Acrylate, gegebenenfalls Hydroxyloder Epoxygruppen enthaltende Acrylate. Als polymerisierbare Komponente können weiterhin ungesättigte, gegebenenfalls funktionalisierte, Amide, Polyester, Polyurethane und Polyether fungieren.

Eine solche strahlungshärtbare Formulierung kann beispielsweise durch Mischen der folgenden Komponenten bereitet werden:
89,0 Teile 75% Epoxyacrylat in Hexandioldiacrylat (welches unter der Bezeichnung ®Ebecryl 604 von der Firma UCB, Belgien, vertrieben wird)
10,0 Teile Polyethylenglykol-400-Diacrylat (welches unter der Bezeichnung ®Sartomer SR 344 von der Firma Sartomer vertrieben wird)
1,0 Teile Silikondiacrylat (welches unter der Bezeichnung ®Ebecryl 350 von der Firma UCB, Belgien, vertrieben wird)
2,0 Teile Phenyl-1-hydroxycyclohexyl-keton (welches unter der Bezeichnung ®Irgacure 184 von der Firma Ciba Spezialitätenchemie, Schweiz, vertrieben wird).

Dieses Material kann durch Bestrahlung mit sichtbarem Licht und mit UV-Licht im Wellenlängenbereich von ungefähr 200 nm bis ungefähr 600 nm vernetzt und somit ausgehärtet werden.

Das Werkstück 102, welches aus einem beliebigen metallischen oder nicht metallischen Material gebildet sein kann, wird in geeigneter Weise, beispielsweise durch Tauchlackieren, durch Spritzlackieren oder durch Besprühen, mit einer Beschichtung aus dem strahlungshärtbaren Material versehen, welche zunächst noch nicht ausgehärtet ist.

Das beschichtete Werkstück 102 wird in den Plasmaerzeugungsraum 104 eingebracht, welches mit einem Prozeßgas, beispielsweise Argon oder Stickstoff, bei einem Arbeitsdruck im Bereich von ungefähr 0,1 Pa bis ungefähr 100 Pa gefüllt ist.

Nachdem das Werkstück 102 in den Plasmaerzeugungsraum 104 eingebracht und in dem Prozeßgas der vorstehend genannte Niederdruck eingestellt worden ist, wird in dem Plasmaerzeugungsraum 104 ein Plasma erzeugt, indem entweder ein statisches elektrisches Feld an den Plasmaerzeugungsraum 104 angelegt wird, wie dies in Fig. 1 durch die Elektroden 106 und 108 schematisch dargestellt ist, und/oder indem ein elektromagnetisches Wechselfeld in den Plasmaerzeugungsraum eingekoppelt wird.

Insbesondere kann vorgesehen sein, daß elektromagnetische Strahlung in den Plasmaerzeugungsraum 104 eingekoppelt wird. Die Frequenz dieser elektromagnetischen Strahlung kann im Mikrowellenbereich (von ungefähr 300 MHz bis ungefähr 300 GHz) oder im Hochfrequenzbereich (von ungefähr 3 kHz bis ungefähr 300 MHz liegen).

Durch Elektronen, die in dem angelegten statischen elektrischen Feld bzw. in dem eingekoppelten elektromagnetischen Wechselfeld Energie aufnehmen, werden die neutralen Teilchen (Atome oder Moleküle) 110 des Prozeßgases stoßionisiert, so daß zusätzliche freie Elektronen 112 und Gasionen 114 entstehen.

Durch Stöße der freien Elektronen 112 und der Gasionen 114 mit weiteren neutralen Gasteilchen entstehen Radikale 116 und angeregte Gasteilchen (Atome oder Moleküle) 118.

Diese angeregten Teilchen des Plasmas emittieren einen Teil der auf sie übertragenen Energie in Form von elektromagnetischer Strahlung 120, welche zumindest zum Teil eine Wellenlänge im sichtbaren Bereich und im UV-Bereich (von ungefähr 200 nm bis ungefähr 600 nm) aufweist.

Ein Teil dieser emittierten UV-Strahlung gelangt aus dem Plasma zu der Beschichtung 100 des innerhalb des Plasmas angeordneten Werkstücks 102, wird dort absorbiert und löst eine Vernetzungsreaktion, beispielsweise eine Polymerisations-, Polykondensations- oder Polyadditionsreaktion, aus, welche zum Aushärten der Beschichtung 100 führt.

Wenn die Beschichtung 100 eine ausreichende Dosis von UV-Strahlung erhalten hat, um eine ausreichende Härtung der Beschichtung 100 zu bewirken, wird die Energiezufuhr zu dem Plasma unterbrochen, so daß wieder eine neutrale Prozeßgas-Atmosphäre entsteht, der Druck in dem Plasmaerzeugungsraum 104 wird auf Atmosphärendruck gebracht, und das Werkstück 102 mit der ausgehärteten Beschichtung 100 wird aus dem Plasmaerzeugungsraum 104 entnommen.

Eine in Fig. 2 schematisch dargestellte, als Ganzes mit 122 bezeichnete Vorrichtung zum Härten einer strahlungshärtbaren Beschichtung 100 an einem Werkstück 102 umfaßt eine gasdichte Plasmakammer 124, deren Innenraum einen Plasmaerzeugungsraum 104 bildet.

Die Plasmakammer 124 kann ein Innenvolumen von beispielsweise ungefähr 100 Litern aufweisen.

Die Plasmakammer 124 ist über eine Absaugleitung 126, die zu einem Vakuum-Pumpsystem 128 führt und mittels eines Sperrventils 130 absperrbar ist, bis auf einen Druck von ungefähr 10⁻³ Pa evakuierbar.

Das an einem Werkstückhalter 131 gehaltene Werkstück 102, das beispielsweise als eine Siliziumscheibe ausgebildet ist, die an ihrer dem Werkstückhalter 131 abgewandten Oberseite mit einer Beschichtung 100 aus dem vorstehend genannten strahlungshärtbaren Material versehen ist, ist über eine (nicht dargestellte) Zugangstüre der Plasmakammer 124 in die in Fig. 2 dargestellte Arbeitsstellung einbringbar.

Mittig über dem in der Arbeitsstellung befindlichen Werkstück 100 ist eine als Ganzes mit 132 bezeichnete Einkopplungseinrichtung für Mikrowellenstrahlung angeordnet, welche eine in einer Hohlleiterstrecke 136 angeordnete Antenne 134 und eine Magnetspulenanordnung 138 umfaßt.

Über die Hohlleiterstrecke 136 ist die Antenne 134 mit einem Magnetron 140 verbunden, das Mikrowellen mit einer Frequenz von beispielsweise 2,45 GHz erzeugt, welche über die Hohlleiterstrecke 136 zu der Antenne 134 gelangen und von dort in den Plasmaerzeugungsraum 104 eingekoppelt werden.

Die Hohlleiterstrecke 136 ist von dem Plasmaerzeugungsraum 104 durch ein Quarzfenster 141 getrennt.

Die Magnetspulenanordnung 138 dient dazu, die ionisierende Wirkung der Mikrowellenstrahlung durch den ECR ("Electron Cyclotron Resonance")-Effekt zu verstärken.

Die Magnetspulenanordnung 138 erzeugt ein statisches Magnetfeld, welches innerhalb des Plasmaerzeugungsraums 104 im wesentlichen parallel zur Achse 142 der von der Antenne 134 ausgesandten Mikrowellenstrahlungskeule ausgerichtet ist. Die Stärke des Magnetfelds wird so eingestellt, daß die Zyklotronfrequenz der Elektronen in dem Magnetfeld der Frequenz der eingestrahlten Mikrowellen entspricht. In diesem Resonanzfall nehmen die freien Elektronen besonders viel Energie aus dem elektromagnetischen Wechselfeld auf, was zu einer besonders effizienten Ionisierung des Prozeßgases führt.

Wird Mikrowellenstrahlung mit einer Frequenz von 2,45 GHz verwendet, so muß ein Magnetfeld mit einer Stärke von 875 Gauss verwendet werden, um den ECR-Effekt zu erzielen.

Symmetrisch zu der Achse 142 der von der Einkopplungseinrichtung 132 erzeugten Mikrowellenstrahlungskeule sind mehrere Einspeiseinrichtungen 144 für Prozeßgas angeordnet, welche jeweils eine abgedichtet in die Plasmakammer 124 geführte Zuführdüse 146 umfassen, die jeweils über eine Zuführleitung 148 mit einem Massenstromregler 149 an ein Gasreservoir 150 angeschlossen ist. Natürlich können auch mehrere Einspeiseinrichtungen 144 an dasselbe Gasreservoir 150 angeschlossen sein.

Jeder der Massenstromregler 149 ist über jeweils eine Steuerleitung 151 an eine Regelungseinheit 153 angeschlossen, welche die Gesamtmenge des dem Plasmaerzeugungsraum 104 zugeführten Prozeßgases in Abhängigkeit von der benötigten Strahlungsmenge regelt.

Als Einkopplungseinrichtung 132 kann insbesondere eine ECR-Plasmaquelle verwendet werden, die unter der Bezeichnung RR 250 von der Firma Roth & Rau Oberflächentechnik AG, D-09337 Hohenstein-Ernstthal, Deutschland, vertrieben wird.

Die vorstehend beschriebene Vorrichtung 122 wird wie folgt betrieben:

Nach dem Einbringen des an dem Werkstückhalter 131 gehaltenen, mit der noch nicht ausgehärteten Beschichtung 100 versehenen Werkstücks 102 in die Plasmakammer 124 wird dieselbe nach Öffnen des Sperrventils 130 mittels des Vakuum-Pumpsystems 128 auf einen Basisdruck von ungefähr 10⁻³ Pa evakuiert.

Anschließend wird Prozeßgas aus den Gasreservoirs 150 über die Einspeiseinrichtungen 144 in den Plasmaerzeugungsraum 104 eingelassen, bis ein Arbeitsdruck von beispielsweise ungefähr 0,3 Pa erreicht ist.

Dabei wird der Gasstrom in die Plasmakammer 124 mittels der Massenstromregler 149 so geregelt, daß der Gasfluß in die Plasmakammer 124 insgesamt ungefähr 10 sccm bis ungefähr 100 sccm (Standardkubikzentimeter pro Minute) beträgt.

Als Prozeßgas wird beispielsweise Argon oder Stickstoff verwendet.

Wenn der gewünschte Arbeitsdruck erreicht ist, wird die von dem Magnetron 140 erzeugte Mikrowellenstrahlung in den Plasmaerzeugungsraum 104 eingekoppelt und damit das Plasma in dem Plasmaerzeugungsraum 104 gezündet.

Die eingekoppelte Mikrowellenleistung beträgt beispielsweise ungefähr 400 Watt bis ungefähr 600 Watt.

Die in die Plasmakammer 124 eingespeisten Gasteilchen werden in der Mikrowellenstrahlungskeule ionisiert und driften von dort weiter durch den Plasmaerzeugungsraum 104, so daß im wesentlichen die gesamte Plasmakammer 124 mit Plasma gefüllt ist.

Durch Stöße der geladenen Teilchen mit den im Plasma angeregten Gasteilchen wird Strahlung im UV-Bereich emittiert, welche von der Beschichtung 100 absorbiert wird und dort die Vernetzungsreaktionen auslöst, welche zum Aushärten der Beschichtung 100 führen.

Nach einer Expositionszeit von beispielsweise 90 Sekunden wird die Plasmabehandlung abgebrochen und die Plasmakammer 124 belüftet.

Das Werkstück 102 mit der ausgehärteten Beschichtung 100 wird entnommen.

Statt der vorstehend beschriebenen ECR-Plasmaquelle könnte auch eine Hochfrequenz-Parallelplatten-Plasmaanordnung verwendet werden, welche ein Parallelplatten-Elektrodensystem umfaßt, das im Abstand von dem Werkstück in dem Plasmaerzeugungraum angeordnet ist. In diesem Fall wird das Plasma gezündet, indem zwischen die Parallelplatten-Elektrodenanordnung und den Werkstückhalter eine Hochfrequenz-Wechselspannung von beispielsweise ungefähr 13,6 MHz angelegt wird. Die eingespeiste Leistung beträgt beispielsweise ungefähr 10 Watt bis ungefähr 200 Watt. Der bevorzugte Arbeitsdruck beträgt ungefähr 1 Pa und wird durch Einspeisen des zu ionisierenden Gases, vorzugsweise Argon, mittel der Massenstromregler in den Zuführleitungen eingestellt.

Im übrigen stimmt die mit Hochfrequenz betriebene Variante der Vorrichtung hinsichtlich Aufbau und Funktion mit der mit Mikrowellen betriebenen Variante überein, auf deren vorstehende Beschreibung insoweit Bezug genommen wird.

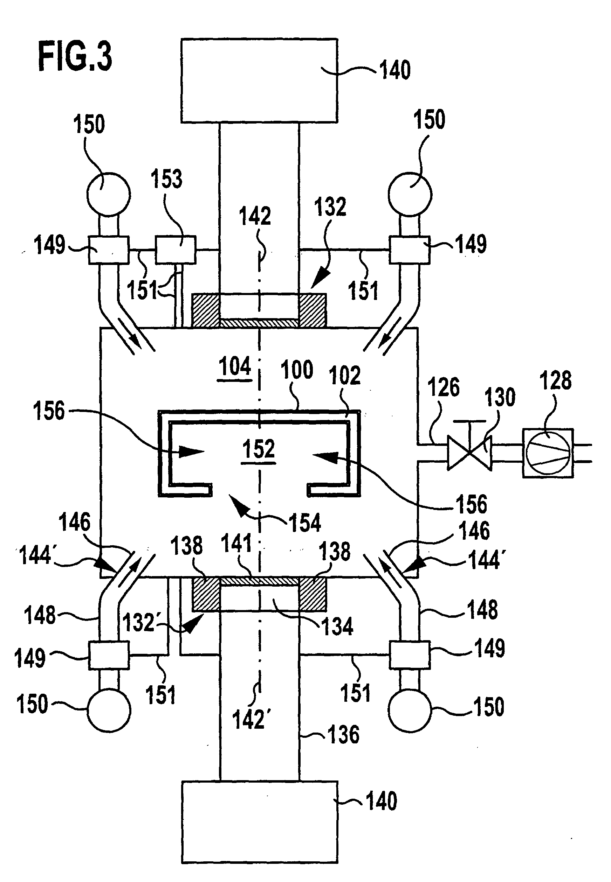

Eine in Fig. 3 schematisch dargestellte zweite Ausführungsform einer Vorrichtung 122 zum Härten einer strahlungshärtbaren Beschichtung 100 an einem Werkstück 102 unterscheidet sich von der vorstehend beschriebenen ersten Ausführungsform dadurch, daß zusätzlich zu der ersten Einkopplungseinrichtung 132 oberhalb der Arbeitsstellung des Werkstücks 102 eine zweite Einkopplungseinrichtung 132' auf der der ersten Einkopplungseinrichtung 132 gegenüberliegenden Seite der Plasmakammer 124 angeordnet ist.

Die zweite Einkopplungseinrichtung 132' entspricht in ihrem Aufbau der ersten Einkopplungseinrichtung 132 und umfaßt insbesondere eine Antenne 134 in einer Hohlleiterstrecke 136, die zu einem Magnetron 140 führt und gegenüber dem Plasmaerzeugungsraum 104 durch eine Quarzglasscheibe 141 abgetrennt ist, sowie eine Magnetspulenanordnung 138 zur Erzeugung des ECR-Effektes.

Ferner sind symmetrisch zu der Achse 142' der von der zweiten Einkopplungseinrichtung 132' erzeugten Mikrowellenstrahlungskeule mehrere Einspeiseinrichtungen 144' für Prozeßgas angeordnet, welche jeweils eine Zuführdüse 146 umfassen, die abgedichtet in den Plasmaerzeugungsraum 104 hineingeführt ist und über eine Zuführleitung 148 mit einem Massenstromregier 149 an ein Gasreservoir 150 angeschlossen ist.

Jeder der Massenstromregler 149 ist über jeweils eine Steuerleitung 151 an die Regelungseinheit 153 angeschlossen, welche die Gesamtmenge des dem Plasmaerzeugungsraum 104 zugeführten Prozeßgases in Abhängigkeit von der benötigten Strahlungsmenge regelt.

Die in Fig. 3 dargestellte zweite Ausführungsform einer Vorrichtung 122 erlaubt es, auch Beschichtungen 100 an komplexer geformten dreidimensionalen Werkstücken 102 auszuhärten, welche beispielsweise, wie das in Fig. 3 gezeigte Werkstück 102, einen Hohlraum 152 mit einer Zugangsöffnung 154 aufweisen, wobei auch die Begrenzungsflächen des Hohlraums mit der auszuhärtenden Beschichtung 100 versehen sind.

Das Werkstück 102 wird in dem Plasmaerzeugungsraum 104 so angeordnet, daß die Zugangsöffnung 154 des Hohlraums 152 der zweiten Einkopplungseinrichtung 132' gegenüberliegt und die Achse 142' der Einkopplungseinrichtung 132' durch die Zugangsöffnung 154 In den Hohlraum 152 hinein weist.

Hierdurch ist gewährleistet, daß die von der zweiten Einkopplungseinrichtung 132' ausgehende Mikrowellenstrahlungskeule in den Hohlraum 152 des Werkstücks 102 hineinreicht, so daß auch im Hohlraum 152 ein Plasma erzeugt wird.

Die durch Stöße mit den geladenen Teilchen des Plasmas angeregten Gasteilchen gelangen durch Diffusion auch in die abgeschatteten Bereiche 156 des Hohlraums 152, in welche keine sichtbare oder UV-Strahlung aus dem außerhalb des Werkstücks 102 liegenden Bereich des Plasmaerzeugungsraums 104 gelangen kann, und emittieren dort sichtbare und UV-Strahlung, welche von der Beschichtung 100 an den Innenwänden der abgeschatteten Bereiche 156 des Hohlraums 152 absorbiert wird. Auf diese Weise kann auch die Beschichtung 100 in diesen abgeschatteten Bereich 156 vollständig ausgehärtet werden.

Im übrigen stimmt die in Fig. 3 dargestellte zweite Ausführungsform einer Vorrichtung 122 zum Härten einer strahlungshärtbaren Beschichtung 100 hinsichtlich Aufbau und Funktion mit der in Fig. 2 dargestellten ersten Ausführungsform überein, auf deren vorstehende Beschreibung insoweit Bezug genommen wird.

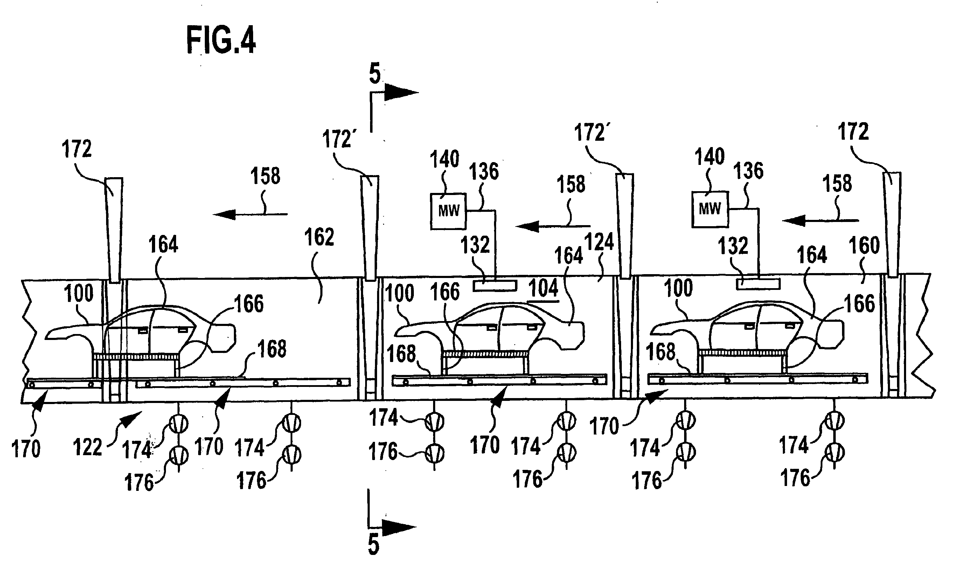

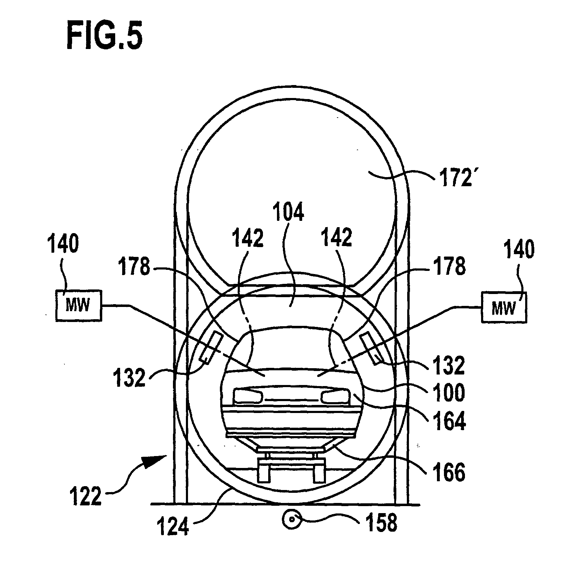

Eine in den Fig. 4 und 5 dargestellte dritte Ausführungsform einer Vorrichtung zum Härten einer strahlungshärtbaren Beschichtung 100 an einem Werkstück 102 umfaßt drei evakuierbare Kammern, die längs einer Förderrichtung 158 aufeinanderfolgen, nämlich eine Vorkammer oder Einschleuskammer 160, eine Plasmakammer 124 und eine Ausschleuskammer 162.

Jede dieser Kammern weist einen Durchmesser von ungefähr 2,5 m und eine Länge von ungefähr 6 m auf, so daß jede Kammer jeweils ein Werkstück in Form einer Fahrzeugkarosserie 164, die auf einem Skidrahmen 166 gehalten ist, aufnehmen kann.

Jeder Skidrahmen umfaßt zwei parallel zur Förderrichtung 158 ausgerichtete Skidkufen 168, mit denen sich der jeweilige Skidrahmen 166 an den Transportrollen von Rollenbahnen 170 abstützen kann, von denen jeweils eine in jeder der Kammern 160, 124 und 162 angeordnet ist.

Der Einlaß der Einschleuskammer 160 und der Auslaß der Ausschleuskammer 162 sind durch jeweils ein vakuumdicht abschließendes äußeres Hubtor 172 verschließbar. Der Durchtritt von der Einschleuskammer 160 in die Plasmakammer 124 und der Durchtritt von der Plasmakammer 124 in die Ausschleuskammer 162 sind durch jeweils ein vakuumdicht abschließendes inneres Hubtor 172' verschließbar.

In den Fig. 4 und 5 sind diese Hubtore 172, 172' in ihrer oberen Offenstellung dargestellt, in welcher die genannten Durchtrittsöffnungen für die Fahrzeugkarosserien 164 geöffnet sind.

Jede der Kammern 160, 124 und 162 ist mittels jeweils einer Vorpumpe 174 und jeweils einer Rootspumpe 176 bis auf einen Arbeitsdruck von ungefähr 1 Pa evakuierbar.

Die Plasmakammer 124 ist mit mehreren Einkopplungseinrichtungen 132 für Mikrowellenstrahlung versehen, von denen eine mittig über der in der Plasmakammer 124 angeordneten Fahrzeugkarosserie 164 angeordnet ist und zwei weitere an den Seitenwänden der Plasmakammer 124 so angeordnet sind, daß sie Fensteröffnungen 178 der Fahrzeugkarosserie 164 gegenüberliegen, so daß die Achsen 142 der von diesen Einkopplungseinrichtungen erzeugten Mikrowellenstrahlungskeulen durch die Fensteröffnungen 178 in den Innenraum der Fahrzeugkarosserie 164 hineinweisen.

Jede der Einkopplungseinrichtungen 132 ist über jeweils eine Hohlleiterstrecke 136 mit einem Magnetron 140 zur Erzeugung von Mikrowellen mit einer Frequenz von 2,45 GHz verbunden.

Ferner sind benachbart zu jeder der Einkopplungseinrichtungen 132 (nicht dargestellte) Gasduschen angeordnet, welche über Zuführleitungen mit Gasreservoirs verbunden sind und durch welche ein Prozeßgas, beispielsweise Stickstoff oder Argon, während des Härtungsvorgangs in die Plasmakammer 124 einspeisbar ist.

Auch in der Einschleuskammer 160 ist eine Einkopplungseinrichtung 132 für Mikrowellenstrahlung vorgesehen, die über eine Hohlleiterstrecke 136 mit einem Magnetron 140 verbunden und mittig über der in der Einschleuskammer 160 angeordneten Fahrzeugkarosserie 164 angeordnet ist.

Die Einkopplungseinrichtungen 132 sind innerhalb der Plasmakammer 124 bzw. innerhalb der Einschleuskammer 160 verschiebbar, um sie in Abhängigkeit von der Geometrie der Fahrzeugkarosserie 164 optimal positionieren, insbesondere möglichst nah an die Fensteröffnungen heranbringen, zu können.

Die vorstehend beschriebene Vorrichtung 122 zum Härten von strahlungshärtbaren Beschichtungen an Fahrzeugkarosserien 164 funktioniert wie folgt:

Die Vorrichtung wird taktweise betrieben, wobei jeweils ein erster Arbeitstakt, ein erster Transporttakt, ein zweiter Arbeitstakt und ein zweiter Transporttakt aufeinanderfolgen und einen Arbeitszyklus der Vorrichtung bilden.

Die gesamte Zykluszeit, das heißt die Summe der Dauer beider Arbeitstakte und beider Transporttakte, beträgt ungefähr 90 Sekunden.

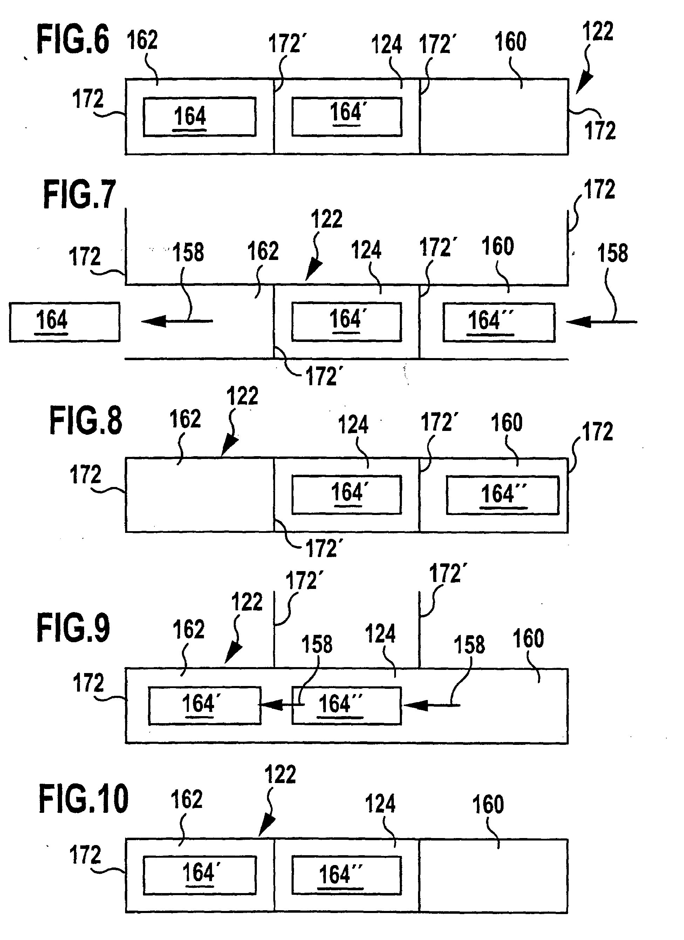

Während des schematisch in Fig. 6 dargestellten ersten Arbeitstaktes sind alle Hubtore 172, 172' geschlossen. In der Ausschleuskammer 162 ist eine Fahrzeugkarosserie 164 und in der Plasmakammer 124 Ist eine weitere Fahrzeugkarosserie 164' angeordnet.

Im ersten Arbeitstakt wird die Ausschleuskammer 162 belüftet, bis in derselben der Umgebungsdruck erreicht ist.

Die Fahrzeugkarosserie 164' in der Plasmakammer 124 wird in dem ersten Arbeitstakt einem Plasmahärtungsvorgang unterzogen, in dem über die Gasduschen das Prozeßgas in den als Plasmaerzeugungsraum 104 dienenden Innenraum der Plasmakammer 124 eingespeist und das Plasma mittels der Mikrowellenstrahlung von den Magnetrons 140 gezündet wird.

Diejenigen Bereiche der Beschichtung 100 der Fahrzeugkarosserie 164', welche direkt an einen Bereich des Plasmaerzeugungsraums 104 angrenzen, in dem Plasma gezündet hat, werden aus diesem Bereich mit sichtbarer Strahlung und UV-Strahlung bestrahlt.

Ferner diffundieren durch Stöße mit geladenen Teilchen des Plasmas angeregte Gasteilchen auch in die abgeschatteten Bereiche im Innenraum der Fahrzeugkarosserie 164' hinein und emittieren dort sichtbares Licht und UV-Licht, so daß die Beschichtung 100 auch in diesen abgeschatteten Bereichen 156 ausgehärtet wird.

Die in die Plasmakammer 124 während des Härtungsvorgangs eingespeiste Mikrowellenleistung beträgt insgesamt ungefähr 10 kW.

Die leere Einschleuskammer 160 wird während des ersten Arbeitstaktes belüftet, bis in derselben der Umgebungsdruck erreicht ist.

Im auf den ersten Arbeitstakt folgenden, in Fig. 7 dargestellten ersten Transporttakt werden die äußeren Hubtore 172 geöffnet. Anschließend wird eine neue Fahrzeugkarosserie 164" aus dem in der Förderrichtung 158 vor der Einschleuskammer 160 liegenden Bereich einer Lackieranlage, in welchem die Fahrzeugkarosserie 164" mit einer Lackierung aus strahlungshärtbarem Material, das beispielsweise die vorstehend genannte Zusammensetzung aufweist, versehen worden ist, in die Einschleuskammer 160 gefördert, während die im ersten Arbeitstakt in der Ausschleuskammer 162 befindliche Fahrzeugkarosserie 164 mittels der Rollenbahn 170 in der Ausschleuskammer 162 in den auf die Ausschleuskammer 162 folgenden Bereich der Lackieranlage weitergefördert wird.

Die Fahrzeugkarosserie 164' verbleibt während des ersten Transporttaktes in der Plasmakammer 124, wobei der Plasmahärtungsvorgang während des ersten Transporttaktes fortgesetzt wird.

An den ersten Transporttakt schließt sich der in Fig. 8 dargestellte zweite Arbeitstakt der Vorrichtung an, in dem wieder alle Hubtore 172, 172' geschlossen sind.

In dem zweiten Arbeitstakt wird der Plasmahärtungsvorgang an der Fahrzeugkarosserie 164' In der Plasmakammer 124 fortgesetzt.

Ferner werden während des zweiten Arbeitstaktes die Einschleuskammer 160 und die Ausschleuskammer 162 mittels der jeweiligen Vorpumpe 174 und der jeweiligen Rootspumpe 176 von Atmosphärendruck auf einen Arbeitsdruck von ungefähr 100 Pa evakuiert. Durch diese Evakuierung kommt es zu einer Vortrocknung der an der Fahrzeugkarosserie 164" in der Einschleuskammer 160 in Form der Lackierung vorhandenen Beschichtung 100.

Mittels der Einkopplungseinrichtung 132 kann ferner Mikrowellenstrahlung vom Magnetron 140 in die Einschleuskammer 160 eingekoppelt werden, um die Beschichtung 100 direkt durch Mikrowellenstrahlung zu trocknen oder, falls gewünscht, bereits in der Einschleuskammer 160 ein Plasma zu zünden, welche sichtbare Strahlung und UV-Strahlung in die Beschichtung emittiert und somit einen ersten Härtungsvorgang der Beschichtung bewirkt.

Nach Ende der vorgesehenen Expositionszeit der Fahrzeugkarosserie 164' in der Plasmakammer von beispielsweise ungefähr 60 Sekunden wird die Energiezufuhr zu dem Plasma unterbrochen und die Gaszufuhr eingestellt.

In dem sich an den zweiten Arbeitstakt anschließenden, in Fig. 9 dargestellten zweiten Transporttakt werden die inneren Hubtore 172' geöffnet, während die äußeren Hubtore 172 geschlossen bleiben.

Im zweiten Transporttakt wird die Fahrzeugkarosserie 164' aus der Plasmakammer 124 mittels der Rollenbahnen in der Plasmakammer 124 und in der Ausschleuskammer 162 in die Ausschleuskammer 162 gefördert.

Gleichzeitig wird im zweiten Transporttakt die Fahrzeugkarosserie 164" aus der Einschleuskammer 160 mittels der Rollenbahnen in der Elnschleuskammer 160 und in der Plasmakammer 124 in die Plasmakammer 124 gefördert.

Anschließend werden die inneren Hubtore 172' geschlossen und der Arbeitszyklus der Vorrichtung 122 beginnt wiederum mit einem ersten Arbeitstakt (Fig. 10), in welchem die Fahrzeugkarosserie 164" in der Plasmakammer 124 einem Plasmahärtungsvorgang unterzogen und die Ausschleuskammer 162 sowie die Einschleuskammer 160 wieder belüftet werden, bis in denselben der Umgebungsdruck erreicht ist.

Ergänzend zu der Plasmahärtung in der Plasmakammer 124 kann auch vorgesehen sein, daß die Fahrzeugkarosserien in der Einschleuskammer 160 thermisch vorbehandelt und/oder in der Ausschleuskammer 162 thermisch nachbehandelt werden.

Die thermische Vor- bzw. Nachbehandlung kann insbesondere einen separaten Wärmehärtungsvorgang umfassen, bei dem die Lackierung durch Wärmezufuhr, beispielsweise mittels Wärmekonvektion und/oder durch Bestrahlung mit infrarotem Licht, auf eine Temperatur im Bereich von beispielsweise ungefähr 50°C bis ungefähr 250°C erwärmt und so gehärtet wird.

Ferner können die Fahrzeugkarosserien auch In der Plasmakammer 124 vor, während und/oder nach dem Plasmahärtungsvorgang thermisch behandelt werden, beispielsweise durch Erwärmung der Lackierung mittels Bestrahlung mit infrarotem Licht.

## Patentansprüche

1. Verfahren zum Härten einer Beschichtung (100) an einem Werkstück (102),
**dadurch kennzeichnet, daß** das Werkstück (102) in einem Plasmaerzeugungsraum (104) angeordnet wird und daß in dem Plasmaerzeugungsraum (104) ein Plasma erzeugt wird, mittels dessen die Beschichtung (100) zumindest teilweise gehärtet wird.

2. Verfahren nach Anspruch 1, **dadurch gekennzeichnet, daß** die Beschichtung (100) strahlungshärtbar ist und daß in dem Plasma eine zum Härten der Beschichtung (100) geeignete Strahlung erzeugt wird.

3. Verfahren nach Anspruch 1 oder 2, **dadurch gekennzeichnet, daß** in dem Plasma eine elektromagnetische Strahlung mit einer Wellenlänge im Bereich von ungefähr 50 nm bis ungefähr 850 nm, insbesondere im Bereich von ungefähr 50 nm bis ungefähr 700 nm, vorzugsweise im Bereich von ungefähr 150 nm bis ungefähr 700 nm, besonders bevorzugt im Bereich von ungefähr 200 nm bis ungefähr 600 nm, erzeugt wird.

4. Verfahren nach Anspruch 3, **dadurch gekennzeichnet, daß** das Werkstück mit einer Beschichtung (100) versehen ist, die durch eine elektromagnetische Strahlung, welche zumindest einen Anteil von UV-Strahlung umfaßt, härtbar ist.

5. Verfahren nach einem der Ansprüche 1 bis 4, **dadurch gekennzeichnet, daß** der Druck in dem Plasmaerzeugungsraum (104) auf einen Wert von höchstens ungefähr 100 Pa, vorzugsweise von höchstens ungefähr 1 Pa, insbesondere von höchstens ungefähr 0,1 Pa, eingestellt wird.

6. Verfahren nach einem der Ansprüche 1 bis 5, **dadurch gekennzeichnet, daß** der Plasmaerzeugungsraum (104) als Prozeßgas Stickstoff und/oder ein Edelgas, vorzugsweise Argon, enthält.

7. Verfahren nach einem der Ansprüche 1 bis 6, **dadurch gekennzeichnet, daß** der Plasmaerzeugungsraum (104) ein Prozeßgas enthält, dem ein Additiv, beispielsweise ein Metall und/oder ein Metallhalogenid, zugesetzt worden ist.

8. Verfahren nach einem der Ansprüche 1 bis 7, **dadurch gekennzeichnet, daß** das Plasma durch Einkopplung von elektromagnetischer Strahlung in den Plasmaerzeugungsraum (104) mittels mindestens einer Einkopplungseinrichtung (132, 132') erzeugt wird.

9. Verfahren nach Anspruch 8, **dadurch gekennzeichnet, daß** das Plasma durch Einkopplung von Mikrowellenstrahlung, vorzugsweise mit einer Frequenz im Bereich von ungefähr 1 GHz bis ungefähr 10 GHz, insbesondere im Bereich von ungefähr 2 GHz bis ungefähr 3 GHz, erzeugt wird.

10. Verfahren nach einem der Ansprüche 8 oder 9, **dadurch gekennzeichnet, daß** die elektromagnetische Strahlung mittels eines Magnetrons (140) erzeugt wird.

11. Verfahren nach einem der Ansprüche 8 bis 10, **dadurch gekennzeichnet, daß** ein Magnetfeld zur Erzeugung eines ECR-Effektes erzeugt wird.

12. Verfahren nach einem der Ansprüche 8 bis 11, **dadurch gekennzeichnet, daß** die elektromagnetische Strahlung mittels mehrerer Einkopplungseinrichtungen (132, 132') in den Plasmaerzeugungsraum (104) eingekoppelt wird.

13. Verfahren nach einem der Ansprüche 8 bis 12, **dadurch gekennzeichnet, daß** das Werkstück (102) einen Hohlraum (152) mit einer Zugangsöffnung (154) aufweist und daß elektromagnetische Strahlung mittels mindestens einer Einkopplungseinrichtung (132) so in den Plasmaerzeugungsraum (104) eingekoppelt wird, daß die elektromagnetische Strahlung durch die Zugangsöffnung (154) In den Hohlraum (152) des Werkstücks (102) gelangt.

14. Verfahren nach einem der Ansprüche 1 bis 13, **dadurch gekennzeichnet, daß** dem Plasmaerzeugungsraum (104) während des Härtungsvorganges ein zu ionisierendes Gas zugeführt wird.

15. Verfahren nach Anspruch 14, **dadurch gekennzeichnet, daß** das zu lonisierende Gas dem Plasmaerzeugungsraum (104) mittels einer Einspeiseinrichtung (144) zugeführt wird, die einer Einkopplungseinrichtung (132, 132') benachbart ist, mittels welcher eine elektromagnetische Strahlung in den Plasmaerzeugungsraum (104) eingekoppelt wird.

16. Verfahren nach einem der Ansprüche 1 bis 15, **dadurch gekennzeichnet, daß** das Werkstück (102) in eine Vorkammer (160) eingebracht und für den Härtungsvorgang aus der Vorkammer (160) in den Plasmaerzeugungsraum (104) überführt wird.

17. Verfahren nach Anspruch 16, **dadurch gekennzeichnet, daß** die Vorkammer (160) nach dem Einbringen des Werkstücks (102) evakuiert wird.

18. Verfahren nach einem der Ansprüche 16 oder 17, **dadurch gekennzeichnet, daß** das Werkstück (102) in der Vorkammer (160) mit elektromagnetischer Strahlung, insbesondere mit Mikrowellenstrahlung, beaufschlagt wird.

19. Verfahren nach einem der Ansprüche 1 bis 18, **dadurch gekennzeichnet, daß** das Werkstück (102) nach dem Härtungsvorgang aus dem Plasmaerzeugungsraum (104) in eine Ausschleuskammer (162) überführt wird.

20. Verfahren nach Anspruch 19, **dadurch gekennzeichnet, daß** die Ausschleuskammer (162) vor dem Überführen des Werkstücks (102) in die Ausschleuskammer (162) evakuiert wird.

21. Werkstück mit einer Beschichtung (100), die nach dem Verfahren gemäß einem der Ansprüche 1 bis 20 gehärtet worden ist.

22. Vorrichtung zum Härten einer, insbesondere strahlungshärtbaren, Beschichtung (100) an einem Werkstück (102), **dadurch gekennzeichnet, daß** die Vorrichtung (122) einen Plasmaerzeugungsraum (104), eine Einrichtung (170) zum Einbringen des Werkstücks (102) in den Plasmaerzeugungsraum (104) und eine Einrichtung (132, 132', 136, 140) zum Erzeugen eines Plasmas in dem Plasmaerzeugungsraum (104) umfaßt.

23. Vorrichtung nach Anspruch 22, **dadurch gekennzeichnet, daß** in dem Plasmaerzeugungsraum (104) ein Plasma erzeugbar ist, das eine elektromagnetische Strahlung mit einer Wellenlänge im Bereich von ungefähr 50 nm bis ungefähr 850 nm, insbesondere im Bereich von ungefähr 50 nm bis ungefähr 700 nm, vorzugsweise im Bereich von ungefähr 150 nm bis ungefähr 700 nm, besonders bevorzugt im Bereich von ungefähr 200 nm bis ungefähr 600 nm, emittiert.

24. Vorrichtung nach einem der Ansprüche 22 oder 23, **dadurch gekennzeichnet, daß** der Druck eines Prozeßgases in dem Plasmaerzeugungsraum (104) auf einen Wert von höchstens ungefähr 100 Pa, vorzugsweise von höchstens ungefähr 1 Pa, insbesondere von höchstens ungefähr 0,1 Pa, einstellbar ist.

25. Vorrichtung nach einem der Ansprüche 22 bis 24, **dadurch gekennzeichnet, daß** der Plasmaerzeugungsraum (104) als Prozeßgas Stickstoff oder ein Edelgas, vorzugsweise Argon, enthält.

26. Vorrichtung nach einem der Ansprüche 22 bis 25, **dadurch gekennzeichnet, daß** die Vorrichtung (122) mindestens eine Einkopplungseinrichtung (132, 132') zum Einkoppeln von elektromagnetischer Strahlung in den Plasmaerzeugungsraum (104) umfaßt.

27. Vorrichtung nach Anspruch 26, **dadurch gekennzeichnet, daß** mittels der Einkopplungseinrichtung (132, 132') eine Mikrowellenstrahlung, vorzugsweise mit einer Frequenz im Bereich von ungefähr 1 GHz bis ungefähr 10 GHz, insbesondere im Bereich von ungefähr 2 GHz bis ungefähr 3 GHz, In den Plasmaerzeugungsraum (104) einkoppelbar ist.

28. Vorrichtung nach einem der Ansprüche 26 oder 27, **dadurch gekennzeichnet, daß** die Vorrichtung (122) eine Einrichtung (140) zum Erzeugen elektromagnetischer Strahlung umfaßt.

29. Vorrichtung nach einem der Ansprüche 26 bis 28, **dadurch gekennzeichnet, daß** die Vorrichtung (122) eine Einrichtung (138) zum Erzeugen eines Magnetfeldes in dem Plasmaerzeugungsraum (104) umfaßt.

30. Vorrichtung nach einem der Ansprüche 26 bis 29, **dadurch gekennzeichnet, daß** die Vorrichtung (122) mehrere Einkopplungseinrichtungen (132, 132') zum Einkoppeln von elektromagnetischer Strahlung in den Plasmaerzeugungsraum (104) umfaßt.

31. Vorrichtung nach einem der Ansprüche 26 bis 30, **dadurch gekennzeichnet, daß** mindestens eine Einkopplungseinrichtung (132') so angeordnet und ausgerichtet ist, daß die mittels dieser Einkopplungseinrichtung (132') in den Plasmaerzeugungsraum (104) eingekoppelte elektromagnetische Strahlung durch eine Zugangsöffnung (154) in einen Hohlraum (152) des in dem Plasmaerzeugungsraum (104) angeordneten Werkstücks (102) gelangt.

32. Vorrichtung nach einem der Ansprüche 22 bis 31, **dadurch gekennzeichnet, daß** die Vorrichtung (122) mindestens eine Einspeiseinrichtung (144) zum Zuführen eines zu ionisierenden Gases zu dem Plasmaerzeugungsraum (104) umfaßt.

33. Vorrichtung nach Anspruch 32, **dadurch gekennzeichnet, daß** die Einspeiseinrichtung (144) benachbart zu einer Einkopplungseinrichtung (132, 132') angeordnet ist, mittels welcher eine elektromagnetische Strahlung in den Plasmaerzeugungsraum (104) einkoppelbar ist.

34. Vorrichtung nach einem der Ansprüche 22 bis 33, **dadurch gekennzeichnet, daß** die Vorrichtung (122) eine Vorkammer (160) zur Aufnahme des Werkstücks (102) vor dem Härtungsvorgang umfaßt.

35. Vorrichtung nach Anspruch 34, **dadurch gekennzeichnet, daß** die Vorkammer (160) evakuierbar ist.

36. Vorrichtung nach einem der Ansprüche 34 oder 35, **dadurch gekennzeichnet, daß** die Vorkammer (160) mit einer Einrichtung (132, 136, 140) zum Beaufschlagen des Werkstücks (102) in der Vorkammer (160) mit einer elektromagnetischen Strahlung, insbesondere mit einer Mikrowellenstrahlung, versehen ist.

37. Vorrichtung nach einem der Ansprüche 34 bis 36, **dadurch gekennzeichnet, daß** die Vorrichtung (122) eine Fördervorrichtung (170), vorzugsweise eine Rollenbahn, zum Fördern des Werkstücks (102) von der Vorkammer (160) in den Plasmaerzeugungsraum (104) umfaßt.

38. Vorrichtung nach einem der Ansprüche 22 bis 37, **dadurch gekennzeichnet, daß** die Vorrichtung (122) eine Ausschleuskammer (162) zur Aufnahme des Werkstücks (102) nach dem Härtungsvorgang umfaßt.

39. Vorrichtung nach Anspruch 38, **dadurch gekennzeichnet, daß** die Ausschleuskammer (162) evakuierbar ist.

40. Vorrichtung nach einem der Ansprüche 38 oder 39, **dadurch gekennzeichnet, daß** die Vorrichtung (122) eine Fördervorrichtung (170), vorzugsweise eine Rollenbahn, zum Fördern des Werkstücks (102) aus dem Plasmaerzeugungsraum (104) in die Ausschleuskammer (162) umfaßt.
